# EUROPEAN PATENT APPLICATION

(11) **EP 4 152 412 A1**
(43) Date of publication of application: **22.03.2023**
(21) Application number: 22195651.9
(22) Date of filing: 14.09.2022
(51) Int. Cl.: H01L 29/786, H01L 29/66, H01L 29/45, H01L 27/12

(54) **GRAPHITIC CARBON CONTACTS FOR DEVICES WITH OXIDE CHANNELS**

(30) Priority: 17.09.2021 US 202117478720
(71) Applicant: Intel Corporation, Santa Clara, CA 95054 (US)
(72) Inventor: SATO, Noriyuki, Hillsboro, OR Oregon 97124 (US); SEN GUPTA, Arnab, Hillsboro, 97123 (US); METZ, Matthew, Portland, 97229 (US); YOO, Hui Jae, Hillsboro, 97124 (US); WEBER, Justin, Beaverton, 97003 (US); LE, Van, Beaverton, 97007 (US); RETASKET, Jason, Beaverton, 97007 (US); SHARMA, Abhishek Anil, Portland, 97229 (US); CHEN, Yu-Jin, Hillsboro, 97124 (US); MATTSON, Eric, Portland, 97225 (US); JOHNSON, Edward, Saint Helens, 97051 (US)
(74) Representative: 2SPL Patentanwälte PartG mbB

(57) **Abstract**

Described herein are integrated circuit devices with metal-oxide semiconductor channels and carbon source and drain (S/D) contacts. S/D contacts conduct current to and from the semiconductor devices, e.g., to the source and drain regions of a transistor. Carbon S/D contacts may be particularly useful with semiconductor devices that use certain channel materials, such as indium gallium zinc oxide.

## Description

### Technical Field

This disclosure relates generally to the field of integrated circuit (IC) structures and devices, and more specifically, to contact materials incorporated in such IC structures and devices.

### Background

In IC devices, electrically conductive contacts provide electrically conductive paths to transistors and other circuit elements. For example, a transistor typically has a source contact and a drain contact, which are coupled to a respective source and drain region in the transistor. The source and drain contacts are typically more conductive than the source and drain regions, e.g., the source and drain contacts may be a metal or metal alloy, while the source and drain regions are doped semiconductors. The source and drain contacts are further coupled to interconnect that delivers signal from or to another portion of the IC device.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional view showing an example arrangement of a one transistor one capacitor (1T-1C) memory cell with carbon source and drain contacts, according to some embodiments of the present disclosure.
FIG. 2 is cross-sectional view showing an example arrangement of a 1T-1C memory cell with layered source and drain contacts, according to some embodiments of the present disclosure.
FIG. 3 is cross-sectional view showing a 1T-1C memory cell with a top-gated with carbon source and drain contacts at the bottom of the transistor, according to some embodiments of the present disclosure.
FIG. 4 is cross-sectional view showing a 1T-1C memory cell with a top-gated transistor with carbon source and drain contacts at the top of the transistor, according to some embodiments of the present disclosure.
FIGS. 5A-5B are perspective and cross-sectional views, respectively, of an example transistor implemented as a FinFET with carbon source and drain contacts, according to some embodiments of the present disclosure.
FIG. 6 is a flowchart illustrating a method for forming an IC device with carbon source and drain contacts, according to some embodiments of the present disclosure.
FIGS. 7A and 7B are top views of a wafer and dies that include carbon source and drain contacts in accordance with any of the embodiments disclosed herein.
FIG. 8 is a cross-sectional side view of an IC device that may include carbon source and drain contacts in accordance with any of the embodiments disclosed herein.
FIG. 9 is a cross-sectional side view of an IC device assembly that may include carbon source and drain contacts in accordance with any of the embodiments disclosed herein.
FIG. 10 is a block diagram of an example computing device that may include carbon source and drain contacts in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices that include an oxide channel region coupled to source and drain contacts that include carbon, and methods for producing such devices. An IC device includes various circuit elements, such as transistors and capacitors, coupled together by metal interconnects. The circuit elements typically include semiconductor materials that are coupled to the interconnects by contacts, also referred to as electrodes.

One example IC device includes memory cells for storing bits of data. A memory cell may include a capacitor for storing a bit value or a memory state (e.g., logical "1" or "0") of the cell, and an access transistor controlling access to the cell (e.g., access to write information to the cell or access to read information from the cell). Such a memory cell may be referred to as a "1T-1C memory cell," highlighting the fact that it uses one transistor (i.e., "IT" in the term "1T-1C memory cell") and one capacitor (i.e., "1C" in the term "1T-1C memory cell"). The capacitor of a 1T-1C memory cell may be coupled to one source or drain (S/D) region/terminal of the access transistor (e.g., to the source region of the access transistor) by a first S/D contact, while the other S/D region of the access transistor may be coupled to a bitline (BL) by a second S/D contact, and a gate terminal of the transistor may be coupled to a word-line (WL) by a gate contact. Various 1T-1C memory cells have, conventionally, been implemented with access transistors being front end of line (FEOL), logic-process based, transistors implemented in an upper-most layer of a semiconductor substrate.

The BL and WL are each formed from metal interconnects that are coupled to additional memory cells, and in particular, access transistors of other memory cells. For example, a BL runs along a column of memory cells, and the BL is coupled to one S/D terminal of each of the access transistors in the column of memory cells via an S/D contact. A WL runs along a row of memory cells, and the WL is coupled to the gate of each of the access transistors in the row of memory cells via a gate contact.

Transistors, such as the access transistor of the memory cell described above, include a channel material in which two S/D regions are formed. The channel material is typically a semiconductor, such as silicon. Various different semiconductor materials have been used as transistor channel materials, such as germanium, indium antimonide, lead telluride, indium arsenide, indium phosphide, gallium arsenide, indium gallium arsenide, gallium antimonide, or other combinations of group III-V, group II-VI, or group IV materials.

One particular channel material of recent interest is indium gallium zinc oxide (IGZO). IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors.

IGZO can be deposited as a uniform amorphous phase while retaining higher carrier mobility than oxide semiconductors such as zinc oxide. Different formulations of IGZO include different ratios of indium, gallium, zinc, and oxide. One particular form of IGZO has the chemical formula InGaO₃(ZnO)₅. In other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

Common source and drain (S/D) contacts for semiconductor devices include one or more metals, such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. For example, titanium nitride (TiN) is one common material for forming S/D contacts. Alternatively, S/D contacts have been formed from electrically conductive oxides, or carbides of one or more metals. For example, indium oxide (In₂O₃) has been used to form S/D contacts in thin film transistors.

When previous S/D contact materials are used in combination with oxide-based channel materials, such as IGZO-based devices (e.g., a transistor with a IGZO channel material), the S/D contacts and channel material can interact and degrade performance of the IC device. In particular, in devices with channel materials that include oxygen and metal that form relatively weak metal-oxygen bonds, previous S/D contact materials interact with the oxygen, e.g., by drawing oxygen atoms out of the channel and towards the S/D contact. For example, in IGZO, the oxygen-zinc and oxygen-indium bonds are relatively weak, and TiN or In₂O₃ S/D contacts draw oxygen from the IGZO, which results in channel defects.

To provide better performance for oxide channel materials, and in particular, for channel materials that include oxygen and weakly-bonded metals, carbon can be used to form the S/D contacts. In particular, a graphite-like carbon provides a low resistance that is suitable for S/D contacts and a relatively high p-type work function, e.g., a similar work function to TiN. Carbon further has a relatively low reactivity with oxygen, so carbon does not degrade the channel material like previous S/D contact materials.

A graphite-like carbon is a crystalline form of carbon with atoms arranged in a hexagonal structure. Graphite-like carbon may include of layers of two-dimensional sheets formed from carbon atoms; the single-layer sheets are referred to as graphene. Graphite-like carbon is a good conductor of heat and electricity, making it suitable for use as an S/D contact.

In some embodiments, the full S/D contacts can be formed from graphite-like carbon. In other embodiments, the S/D contacts may have two or more layers, e.g., a graphite-like carbon layer coupled to the channel material, and a second layer (e.g., a TiN layer) separated from the channel material by the carbon layer. The S/D contacts and channel material may be used to form transistors of various architectures, including planar and non-planar transistors, and the S/D contacts and channel material may be used to form various circuits. For example, an IGZO-based transistor with carbon S/D contacts may be coupled to a capacitor, forming a 1T-1C memory cell.

More generally, the carbon S/D contacts described herein may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### Example memory cell with carbon S/D contacts

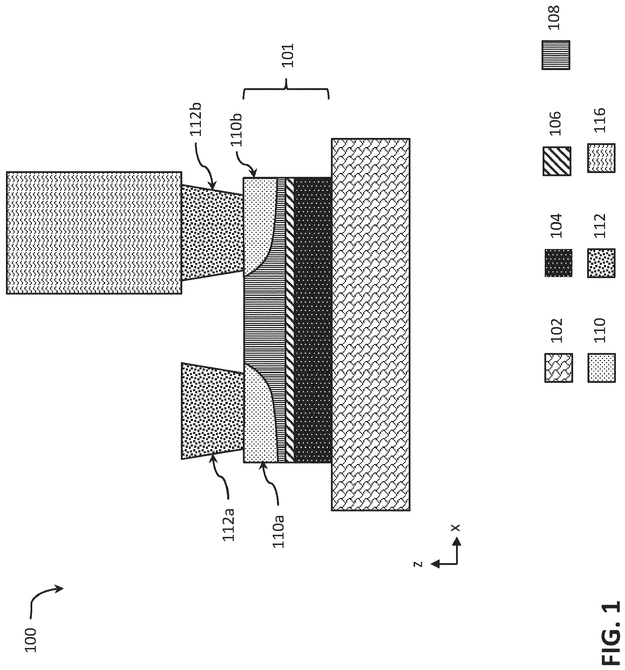

FIG. 1 is a cross-sectional view showing an example arrangement of a one transistor one capacitor (1T-1C) memory cell 100 with carbon source and drain contacts, according to some embodiments of the present disclosure.

The 1T-1C memory cell 100 is formed over a support structure 102. The 1T-1C memory cell 100 includes a transistor 101 coupled to a pair of S/D contacts 112a and 112b, where the S/D contacts 112 include carbon. One of the S/D contacts 112b is coupled to a capacitor 116 for storing a bit of data. The transistor 101 is an access transistor that controls access to the capacitor 116 to write information to the capacitor 116 or to read information from the capacitor 116. A number of elements referred to in the description of FIGs. 1-5 with reference numerals are illustrated in these figures with different patterns, with a legend showing the correspondence between the reference numerals and patterns being provided at the bottom or side of each drawing page containing FIGs. 1-5. For example, the legend in FIG. 1 illustrates that FIG. 1 uses different patterns to show a support structure 102, a gate electrode 104, a gate dielectric 106, a channel material 108, S/D regions 110, carbon S/D contacts 112, and the capacitor 116.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

The transistor 101 includes a gate electrode 104, a gate dielectric 106, a channel material 108, and two S/D regions 110. The gate electrode 104 may be coupled to a WL, e.g., via a gate via not specifically shown in FIG. 1. The WL may be coupled to a row of similar memory cells. A first S/D region 110a is coupled to a first S/D contact 112a, and a second S/D region 110b is coupled to a second S/D contact 112b. The first S/D contact 112a may be coupled to a BL that is coupled to a column of similar memory cells. The second S/D contact 112a is coupled to one electrode of a capacitor 116. The capacitor 116 may have a second electrode coupled to a plateline (PL), not shown in FIG. 1, as is known in the art.

In general, implementations of the present disclosure may be formed or carried out on a support structure 102, such as a semiconductor substrate composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which a semiconductor device may be built falls within the spirit and scope of the present disclosure. In various embodiments the support structure 102 may include any such substrate that provides a suitable surface for providing the memory cell shown in FIG. 1.

The transistor 101 is formed over the support structure 102. The gate electrode 104 and the gate dielectric 106 form a gate stack. The gate electrode 104 may include at least one P-type work function metal or N-type work function metal, depending on whether the transistor 101 is a PMOS transistor or an NMOS transistor (P-type work function metal used as the gate electrode 104 when the transistor 101 is a PMOS transistor and N-type work function metal used as the gate electrode 104 when the transistor 101 is an NMOS transistor). For a PMOS transistor, metals that may be used for the gate electrode 104 may include, but are not limited to, ruthenium, palladium, platinum, cobalt, nickel, and conductive metal oxides (e.g., ruthenium oxide). For an NMOS transistor, metals that may be used for the gate electrode 104 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). Other materials that may be used include titanium nitride, tantalum nitride, hafnium nitride, tungsten, iridium, copper, or degenerately doped poly-silicon. In some embodiments, the gate electrode 104 may consist of a stack of two or more metal layers, where one or more metal layers are work function metal layers and at least one metal layer is a fill metal layer. Further layers may be included next to the gate electrode 104 for other purposes, such as to act as a diffusion barrier layer or/and an adhesion layer.

In some embodiments, the gate dielectric 106 may include one or more high-k dielectrics. Examples of high-k materials that may be used in the gate dielectric 106 may include, but are not limited to, hafnium oxide, hafnium silicon oxide, lanthanum oxide, lanthanum aluminum oxide, zirconium oxide, zirconium silicon oxide, silicon oxide, tungsten oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, lead zinc niobate, aluminum nitride, and silicon nitride. In some embodiments, the gate dielectric 106 may consist of a stack of two or more dielectric layers, e.g., a stack of two or more of the high-k materials listed above. The gate dielectric 106, or a layer of the gate dielectric 106, may comprise a mixture of the materials listed above and/or of other oxides, nitrides, or oxynitrides.

The gate dielectric 106 may be deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In some embodiments, an annealing process may be carried out on the gate dielectric 106 during manufacture of the transistor 101 to improve the quality of the gate dielectric 106. The gate dielectric 106 may have a thickness, a dimension measured in the direction of the z-axis of the reference coordinate system x-y-z shown in FIG. 1, that may, in some embodiments, be between 0.5 nanometers and 20 nanometers, including all values and ranges therein (e.g., between 2 and 6 nanometers).

The channel material 108 may be composed of semiconductor material systems including, for example, N-type or P-type materials systems. In certain embodiments, the channel material 108 may include a high mobility oxide semiconductor material, such as IGZO, or other combinations of materials that include oxygen, such as combinations of indium, gallium, zinc, and/or oxygen.

More generally, for some example N-type transistor embodiments (i.e., for the embodiments where the transistor 101 is an N-type metal-oxide-semiconductor (NMOS)), the channel material 108 may advantageously include a III-V material having a high electron mobility, such as, but not limited to InGaAs, InP, InSb, and InAs. For some such embodiments, the channel material 108 may be a ternary III-V alloy, such as InGaAs. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel material 108 may be an intrinsic III-V material, i.e., a III-V semiconductor material not intentionally doped with any electrically active impurity. In alternate embodiments, a nominal impurity dopant level may be present within the channel material 108, for example to further fine-tune a threshold voltage Vt, or to provide HALO pocket implants, etc. Even for impurity-doped embodiments however, impurity dopant level within the channel material 108 may be relatively low, for example below 10¹⁵ dopant atoms per cubic centimeter (cm⁻³), and advantageously below 10¹³ cm⁻³.

For some example P-type transistor embodiments (i.e., for the embodiments where the transistor 101 is a P-type metal-oxide-semiconductor (PMOS)), the channel material 108 may advantageously be a group IV material having a high hole mobility, such as, but not limited to Ge or a Ge-rich SiGe alloy. For some example embodiments, the channel material 108 may have a Ge content between 0.6 and 0.9, and advantageously may be at least 0.7. In some embodiments with highest mobility, the channel material 108 may be intrinsic III-V (or IV for P-type devices) material and not intentionally doped with any electrically active impurity. In alternate embodiments, one or more a nominal impurity dopant level may be present within the channel material 108, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³.

In some embodiments, the transistor 101 may be a thin film transistor (TFT). A TFT is a special kind of a field-effect transistor made by depositing a thin film of an active semiconductor material, as well as a dielectric layer and metallic contacts, over a supporting layer that may be a non-conducting layer. At least a portion of the active semiconductor material forms a channel of the TFT. If the transistor 101 is a TFT, the channel material 108 may include a high mobility oxide semiconductor material, such as tin oxide, antimony oxide, indium oxide, indium tin oxide, titanium oxide, zinc oxide, indium zinc oxide, IGZO, gallium oxide, titanium oxynitride, ruthenium oxide, aluminum zinc oxide, or tungsten oxide. In general, if the transistor 101 is a TFT, the channel material 108 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antonomide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc. In some embodiments, the channel material 108 may have a thickness between about 5 and 75 nanometers, including all values and ranges therein. In some embodiments, a thin film channel material 108 may be deposited at relatively low temperatures, which allows depositing the channel material 108 within the thermal budgets imposed on back end fabrication to avoid damaging other components, e.g., front end components such as the logic devices.

The S/D regions 110 are formed in the channel material 108. The S/D regions 110 may generally be formed using either an implantation/diffusion process or an etching/deposition process. In the former process, dopants such as boron, aluminum, antimony, phosphorous, or arsenic may be ion-implanted into the channel material to form the S/D regions 110. An annealing process that activates the dopants and causes them to diffuse further into the channel material 108 typically follows the ion implantation process. In the latter process, the channel material 108 may first be etched to form recesses at the locations of the S/D regions 110. An epitaxial deposition process may then be carried out to fill the recesses with material that is used to fabricate the S/D regions 110. In some implementations, the S/D regions 110 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 110 may be formed using one or more alternate semiconductor materials such as germanium or a group III-V material or alloy. And in further embodiments, one or more layers of metal and/or metal alloys may be used to form the S/D regions 110.

The S/D contacts 112 are coupled to the channel material 108, and in particular, to the S/D regions 110. The first S/D contact 112a is coupled to the first S/D region 110a, and the second S/D contact 112b is coupled to the second S/D region 110b. An insulator material (not shown in FIG. 1) may be formed between the S/D contacts 112 and electrically separate the two S/D contacts 112a and 112b. The insulator material may be formed as a layer over the transistor 101 and similar transistors, where the insulator material layer further electrically separates transistors from one another. The S/D contacts 112 may be formed in the insulator material by patterning the S/D contacts 112 in the insulator layer and depositing the S/D contact material in the patterned regions.

The S/D contacts 112 are advantageously formed of carbon, and in particular, a graphite-like, or graphitic, carbon. As noted above, graphitic carbon has low resistance, making it suitable for forming the S/D contacts 112. Graphitic carbon further has a relatively high p-type work function, e.g., between 4.3 and 4.7 eV, depending on the thickness of the S/D contacts 112. As described above, the channel material 108 may include a combination of oxygen and one or more metals, such as IGZO. Carbon is particularly well-suited for use in S/D contacts 112 coupled to oxide channel materials, because carbon has a relatively low reactivity with oxygen. When carbon S/D contacts are used, the S/D contacts 112 do not degrade the channel material 108 like previous S/D contact materials, such as TiN.

The S/D contacts 112 may have a thickness measured in the z-direction in the reference coordinate system shown in FIG. 1 of between 1 nanometers and 50 nanometers, including all values and ranges therein. In some embodiments, the S/D contacts 112 have a thickness between 30 and 40 nanometers.

### Example memory cell with layered S/D contacts

In the example shown in FIG. 1, the S/D contacts 112 are shown as having a uniform material, e.g., the full S/D contacts 112a and 112b are formed of carbon. In other examples, layered S/D contacts are used, where the S/D contact includes one layer of graphite-like carbon adjacent to the S/D regions, and one or more additional layers of other materials formed over the carbon layer.

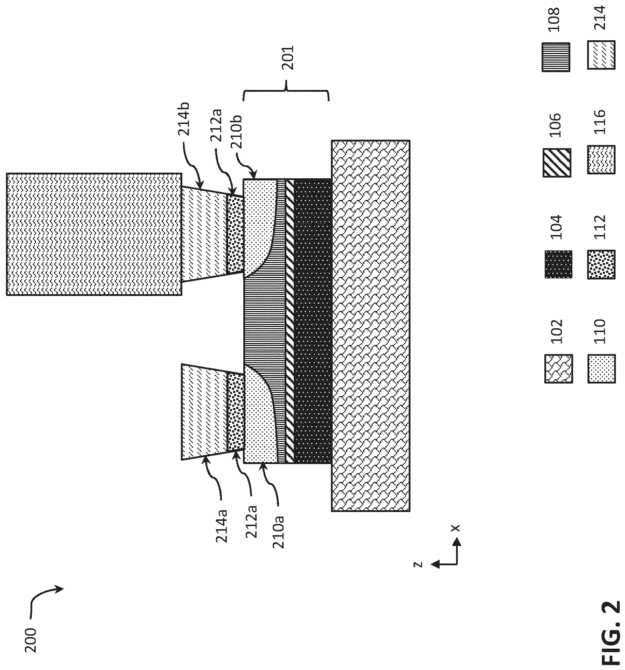

FIG. 2 is cross-sectional view showing an example arrangement of a 1T-1C memory cell 200 with layered S/D contacts, according to some embodiments of the present disclosure. The memory cell 200 is formed over a support structure 102, as described with respect to FIG. 1. The memory cell 200 includes a transistor 201 coupled to a pair of S/D contacts, where each S/D contact includes a first layer 212 and second layer 214. The transistor 201 is an access transistor that controls access to the capacitor 116 to write information to the capacitor 116 or to read information from the capacitor 116. The transistor 201 includes a gate electrode 104, gate dielectric 106, channel material 108, and S/D regions 110, which are similar to the corresponding elements shown in FIG. 1 and described above. The two S/D regions are labelled 210a and 210b.

In the S/D contacts, the first layer 212 is a carbon layer, illustrated using the same material 112 as the carbon S/D contacts 112a and 112b shown in FIG. 1. The carbon layers 212a and 212b are positioned adjacent to the S/D regions 210a and 210b. The second layer 214 is another electrode material, such as TiN. The carbon layers 212a and 212b are positioned between the second layers 214a and 214b (e.g., the TiN layers) and the S/D regions 210a and 210b, so that the carbon layers 212 protect the channel material 108 from the electrode material 214. The first carbon layer 212 may have a thickness measured in the z-direction in the reference coordinate system shown in FIG. 2 of between 0.5 nanometers and 20 nanometers, including all values and ranges therein. In some embodiments, the first carbon layer has a thickness between 1 and 10 nanometers. The second layer 214 of the electrode contact may have a thickness of, for example, between 1 nanometers and 50 nanometers, including all values and ranges therein.

In other examples, instead of TiN, other materials suitable for forming S/D contacts may be used to form the second layer 214. For example, the electrically conductive materials of the second layer 214 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the second layer 214 may include one or more electrically conductive alloys, oxides, or carbides of one or more metals. In some embodiments, the second layer 214 may include a doped semiconductor, such as silicon or another semiconductor doped with an N-type dopant or a P-type dopant. Metals may provide higher conductivity, while doped semiconductors may be easier to pattern during fabrication. While a single second layer 214 is depicted in FIG. 2, in other examples, the S/D contacts may include three or more layers, where the layer adjacent to the S/D regions 210a and 210b is or includes carbon, and two or more upper layers are formed of other materials and/or additional layers of carbon.

### Alternate arrangements of memory cells with carbon S/D contacts

While the transistors 101 and 201 depicted in FIGs. 1 and 2 have a back-side gate stack and front-side S/D contacts, in other embodiments, different transistor architectures may be used for forming the memory cells with carbon S/D contacts. For example, the gate stack may be on the front-side, or one or both of the S/D regions and S/D contacts may be on the back-side. In other embodiments, the transistors may have a non-planar architecture, such as a FinFET. In some embodiments, the transistor is a nanoribbon-based transistor (or, simply, a nanoribbon transistor, e.g., a nanowire transistor). In a nanoribbon transistor, a gate stack that may include a stack of one or more gate electrode metals (e.g., the materials discussed with respect to the gate electrode 104) and, optionally, a stack of one or more gate dielectrics (e.g., one of the gate dielectrics 106) may be provided around a portion of an elongated semiconductor structure called "nanoribbon", forming a gate on all sides of the nanoribbon. The portion of the nanoribbon around which the gate stack wraps around is referred to as a "channel" or a "channel portion," and may be formed of any of the channel materials 108 described above, and in particular, an oxide-metal channel material. The S/D regions are provided on the opposite ends of the nanoribbon, on either side of the gate stack, forming, respectively, a source and a drain of such a transistor.

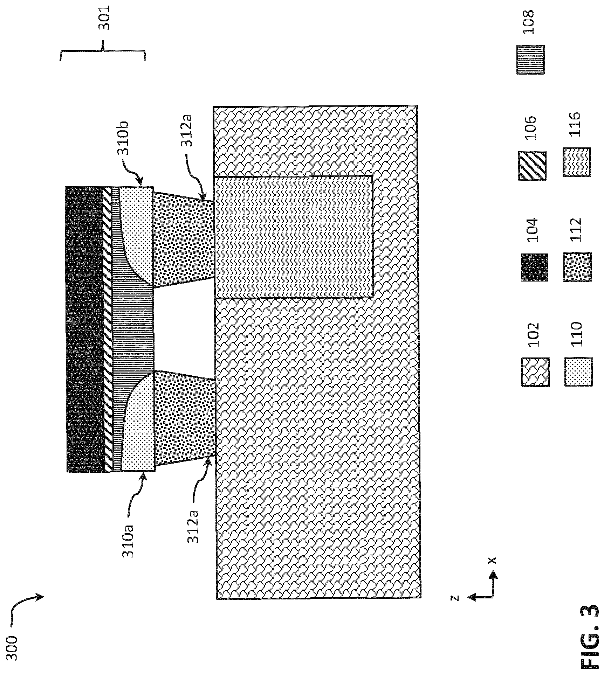

FIGs. 3-5 illustrate three particular examples of alternate memory cell arrangements that include carbon S/D contacts. Each of the memory cells includes the materials described with respect to FIG. 1, i.e., a support structure 102, gate electrode 104, gate dielectric 106, channel material 108, S/D regions 110, carbon S/D contacts 112, and capacitor 116. While the S/D contacts illustrated in FIGs. 3-5 include full carbon contacts, in other embodiments, each of the S/D contacts depicted in FIGs. 3-5 may be a layered contact with a carbon layer and one or more layers formed from other materials, as shown in FIG. 2. If layered contacts are used, a carbon layer is adjacent to the S/D regions and between the S/D region and the other material(s) (e.g., TiN).

FIG. 3 is cross-sectional view showing a 1T-1C memory cell 300 with a top-gated with carbon S/D contacts at the bottom of the transistor, according to some embodiments of the present disclosure. In this example, the capacitor 116 is formed in the support structure 102, and the access transistor 301 is formed over the capacitor 116. In another example, rather than forming the capacitor 116 in the support structure 102, the capacitor 116 is formed over the support structure 102 (e.g., in an inter-layer dielectric (ILD) formed over the support structure 102), and the transistor 301 is formed over the capacitor 116. The memory cell 300 includes two S/D contacts 312a and 312b that include carbon. The transistor 301 includes a gate electrode 104, gate dielectric 106, channel material 108, and S/D regions 110, which are similar to the corresponding elements shown in FIG. 1 and described above. The two S/D regions are labelled 310a and 310b, and are formed over the S/D contacts 312a and 312b. The transistor 301 is flipped relative to the transistor 101, with the S/D regions 310a and 310b at the back-side of the transistor 301, and the gate stack at the front-side.

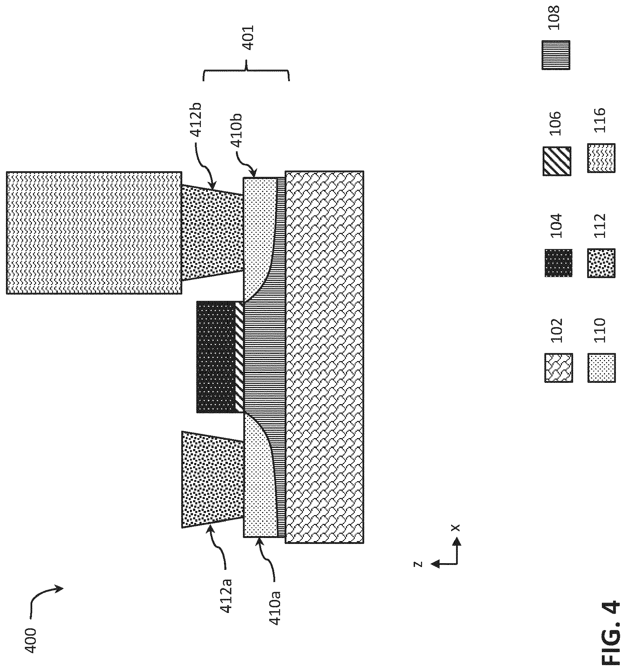

FIG. 4 is cross-sectional view showing a 1T-1C memory cell 400 with a top-gated transistor with carbon S/D contacts at the top of the transistor, according to some embodiments of the present disclosure. The transistor 401 includes a gate electrode 104, gate dielectric 106, channel material 108, and S/D regions 110, which are similar to the corresponding elements shown in FIG. 1 and described above. In this example, the channel material 108 is formed over the support structure 102, and the gate stack (including the gate electrode and gate dielectric 106) as well as the S/D contacts 412a and 412b are formed over the channel material 108. In particular, the S/D contacts 412a and 412b are formed over the S/D regions 410a and 410b on either side of the channel material 108, and the gate stack is formed over a center portion of the channel material, between the S/D contacts 412. The two S/D contacts 412a and 412b include carbon. The capacitor 116 is formed over one of the S/D contacts 412b. A BL and a WL (not shown in FIG. 4) may be coupled to the first S/D contact 412a and the gate electrode 104, respectively.

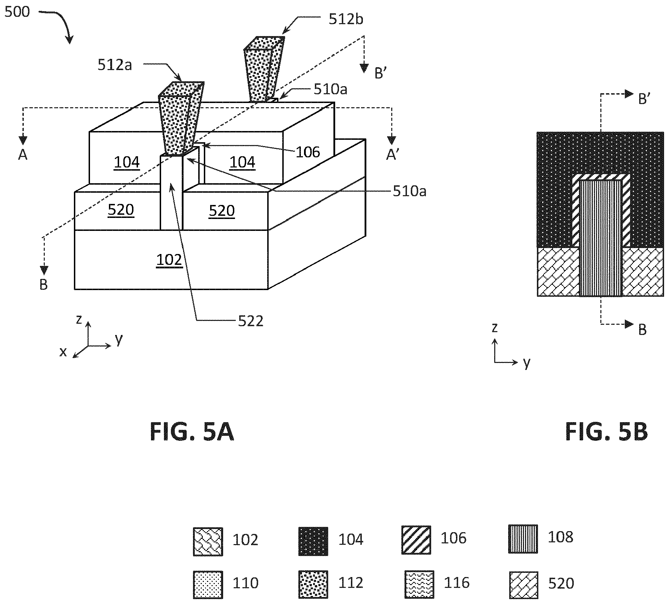

FIGS. 5A-5B are perspective and cross-sectional views, respectively, of an example transistor implemented as a FinFET with carbon S/D contacts, according to some embodiments of the present disclosure. FinFETs refer to transistors having a non-planar architecture where a fin, formed of one or more semiconductor materials, extends away from a base (where the term "base" refers to any suitable support structure on which a transistor may be built, e.g., a substrate). A portion of the fin that is closest to the base may be enclosed by an insulator material. Such an insulator material, typically an oxide, is commonly referred to as a "shallow trench isolation" (STI), and the portion of the fin enclosed by the STI is typically referred to as a "subfin portion" or simply a "subfin." A gate stack that includes at least a layer of a gate electrode material and, optionally, a layer of a gate dielectric may be provided over the top and sides of the remaining upper portion of the fin (i.e. the portion above and not enclosed by the STI), thus wrapping around the upper-most portion of the fin. The portion of the fin over which the gate stack wraps around is typically referred to as a "channel portion" of the fin because this is where, during operation of the transistor, a conductive channel forms, and is a part of an active region of the fin. Two S/D regions are provided on the opposite sides of the gate stack, forming a source and a drain terminal of a transistor. FinFETs may be implemented as "tri-gate transistors," where the name "tri-gate" originates from the fact that, in use, such transistors may form conducting channels on three "sides" of the fin. FinFETs potentially improve performance relative to single-gate transistors and double-gate transistors.

FIG. 5A is a perspective view, while FIG. 5B is a cross-sectional side view of a FinFET 500 with carbon S/D contacts, according to some embodiments of the disclosure. FIGS. 5A-5B illustrate the support structure 102, gate electrode 104, gate dielectric 106, channel material 108, and S/D regions 110 as described above. The two S/D regions are labeled as 510a and 510b in FIG. 5A. As shown in FIGS. 5A-5B, when the transistor 500 is implemented as a FinFET, the FinFET 500 may further a fin 522, and an STI material 520 enclosing the subfin portion of the fin 522. Two carbon S/D contacts 512a and 512b are further shown in FIGS. 5A-5B. The cross-sectional side view of FIG. 5B is the view in the y-z plane of the example coordinate system x-y-z shown in FIG. 5A, with the cross-section of FIG. 5B taken across the fin 522 (e.g., along the plane shown in FIG. 5A as a plane AA'). On the other hand, the cross-sectional side view of FIG. 4 is the view in the x-z plane of the example coordinate system shown in FIG. 5A with the cross-section taken along the fin 522 for one example portion of the gate stack (e.g., along the plane shown in FIG. 5A and in FIG. 5B as a plane BB').

As shown in FIGS. 5A-5B, the fin 522 may extend away from the support structure 102 and may be substantially perpendicular to the support structure 102. The fin 704 may include one or more semiconductor materials, e.g. a stack of semiconductor materials, so that the upper-most portion of the fin (namely, the portion of the fin 522 enclosed by the gate electrode 104 and gate dielectric 106) may serve as the channel region of the FinFET 500. Therefore, the upper-most portion of the fin 522 may be formed of the channel material 108 as described above.

The subfin of the fin 522 may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth. For some example N-type transistor embodiments, the subfin portion of the fin 522 may be a III-V material having a band offset (e.g., conduction band offset for N-type devices) from the channel portion. Example materials, include, but are not limited to, GaAs, GaSb, GaAsSb, GaP, InAIAs, GaAsSb, AlAs, AIP, AlSb, and AIGaAs. In some N-type transistor embodiments of the FinFET 500 where the channel portion of the fin 522 (e.g., the channel portion) is InGaAs, the subfin may be GaAs, and at least a portion of the subfin may also be doped with impurities (e.g., P-type) to a greater impurity level than the channel portion. In an alternate heterojunction embodiment, the subfin and the channel portion of the fin 522 are each, or include, group IV semiconductors (e.g., Si, Ge, SiGe). The subfin of the fin 522 may be a first elemental semiconductor (e.g., Si or Ge) or a first SiGe alloy (e.g., having a wide bandgap). For some example P-type transistor embodiments, the subfin of the fin 522 may be a group IV material having a band offset (e.g., valance band offset for P-type devices) from the channel portion. Example materials, include, but are not limited to, Si or Sirich SiGe. In some P-type transistor embodiments, the subfin of the fin 522 is Si and at least a portion of the subfin may also be doped with impurities (e.g., N-type) to a higher impurity level than the channel portion.

As further shown in FIGS. 5A-5B, the STI material 520 may enclose portions of the sides of the fin 522. A portion of the fin 522 enclosed by the STI 520 forms a subfin. In various embodiments, the STI material 520 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 520 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

The gate stack (i.e., the gate dielectric 106 and gate electrode 104) may wrap around the upper portion of the fin 522 (the portion above the STI 520), as shown in FIGS. 5A-5B, with a channel portion of the fin 522 corresponding to the portion of the fin 522 wrapped by the gate stack as shown in FIGS. 5A-5B. In particular, the gate dielectric 106 (if used) may wrap around the upper-most portion of the fin 522, and the gate electrode 104 may wrap around the gate dielectric 106. The interface between the channel portion and the subfin portion of the fin 522 is located proximate to where the gate electrode 104 ends.

In some embodiments, the FinFET 500 may have a gate length, GL, (i.e. a distance between the first S/D region 510a and the second S/D region 510b), a dimension measured along the fin 522 in the direction of the x-axis of the example reference coordinate system x-y-z shown in FIG. 4 and FIGS. 5A-5B, which may, in some embodiments, be between about 5 and 40 nanometers, including all values and ranges therein (e.g. between about 22 and 35 nanometers, or between about 20 and 30 nanometers). The fin 522 may have a thickness, a dimension measured in the direction of the y-axis of the reference coordinate system x-y-z shown in FIGS. 5A-5B, that may, in some embodiments, be between about 5 and 30 nanometers, including all values and ranges therein (e.g. between about 7 and 20 nanometers, or between about 10 and 15 nanometers). The fin 522 may have a height, a dimension measured in the direction of the z-axis of the reference coordinate system x-y-z shown in FIG. 4, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 522 illustrated in FIGS. 5A-5B is shown as having a rectangular cross-section in a y-z plane of the reference coordinate system shown, the fin 522 may instead have a cross-section that is rounded or sloped at the "top" of the fin 522, and the gate stack may conform to this rounded or sloped fin 522. In use, the FinFET 500 may form conducting channels on three "sides" of the channel portion of the fin 522, potentially improving performance relative to single-gate transistors (which may form conducting channels on one "side" of a channel material or substrate) and double-gate transistors (which may form conducting channels on two "sides" of a channel material or substrate).

The S/D contacts 512a and 512b are electrically connected to the S/D regions 510a and 510b and extend in the same vertical direction with respect to the fin 522. In another example, one of the S/D contacts (e.g., the first S/D contact 512a) may be electrically connected to the first S/D region 510a and extend from the first S/D region 510a towards the support structure 102, thus forming a back-side S/D contact for the FinFET 500. In still another implementation, both the first S/D contact 512a and the second S/D contact 512b extend from the first and second S/D region 510a and 510b towards the support structure, thus forming two back-side S/D contacts for the FinFET 500, similar to the illustration of FIG. 3.

### Example Method for Forming IC Device with Carbon S/D contacts

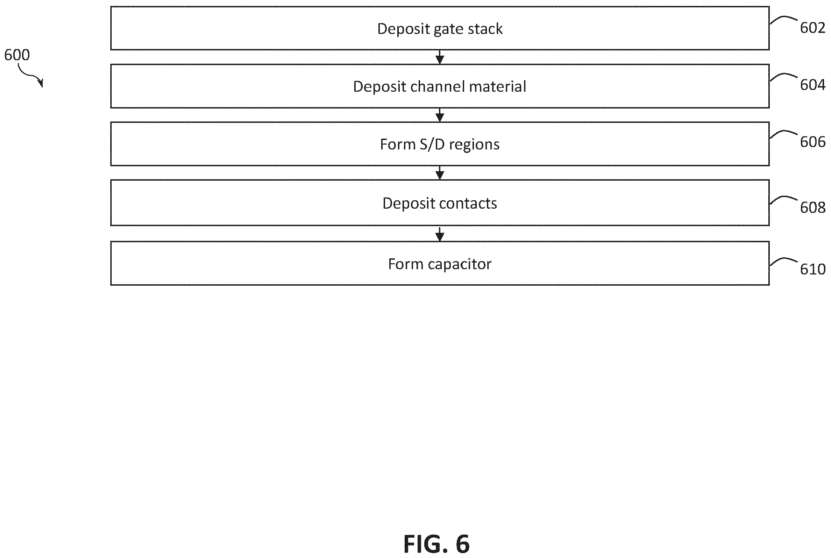

FIG. 6 is a flowchart illustrating a method for forming an IC device with carbon source and drain contacts, according to some embodiments of the present disclosure. The method begins with depositing 602 a gate stack, e.g., the gate electrode 104 and gate dielectric 106 shown in FIG. 1. The gate stack may be deposited on a support structure 102, e.g., over a support structure 102 with metal interconnects formed therein or thereon. The gate electrode 104 is deposited so that it is coupled to an interconnect, e.g., a WL.

The method proceeds with depositing 604 a channel material, e.g., the channel material 108 shown in FIG. 1. The channel material may include oxygen and one or more metals, e.g., IGZO or another combination of oxygen and one or more of indium, gallium, and zinc.

The method proceeds with forming 606 S/D regions in or over the channel material, e.g., the S/D regions 110a and 110b shown in FIG. 1. The S/D regions may be formed as described with respect to FIG. 1. The gate stack, channel material, and S/D regions form a transistor, e.g., the transistor 101.

The method proceeds with depositing 608 S/D contacts over the transistor, e.g., depositing the S/D contacts 112a and 112b, which are in contact with the S/D regions 110a and 110b. The S/D contacts include carbon, e.g., the full S/D contacts may be composed of a graphite-like carbon (as shown in FIG. 1), or the S/D contacts may include two or more layers, with the layer nearest to the S/D regions comprising carbon (as shown in FIG. 2).

The method proceeds with forming 610 a capacitor, e.g., the capacitor 116 shown in FIG. 1, over one of the S/D contacts, thus realizing a 1T-1C memory cell.

The 1T-1C memory cell is just one example IC device that may include carbon S/D contacts. As another example, the capacitor may not be formed, resulting in a transistor with carbon contacts.

The steps shown in FIG. 6 may be performed in a different order to achieve IC devices with different arrangements, e.g., any of the arrangements shown in FIGs. 3-5. For example, to form the memory cell shown in FIG. 3, the steps 602-610 may be performed in an opposite order.

### Example devices

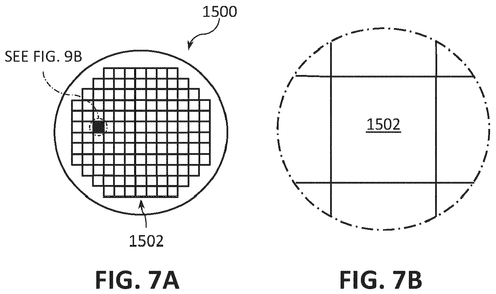

The interconnects with barrier material liners disclosed herein may be included in any suitable electronic device. FIGS. 7-10 illustrate various examples of apparatuses that may include the interconnects with barrier material liners disclosed herein.

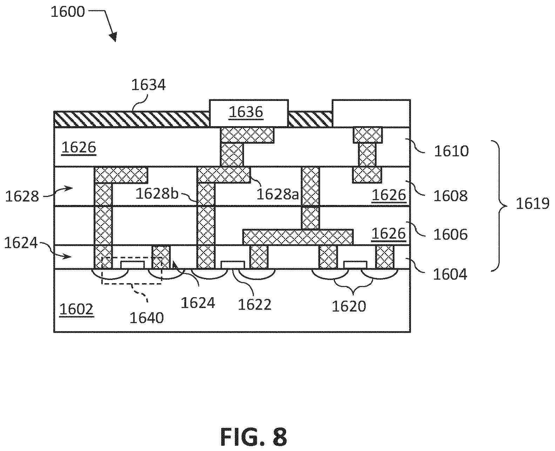

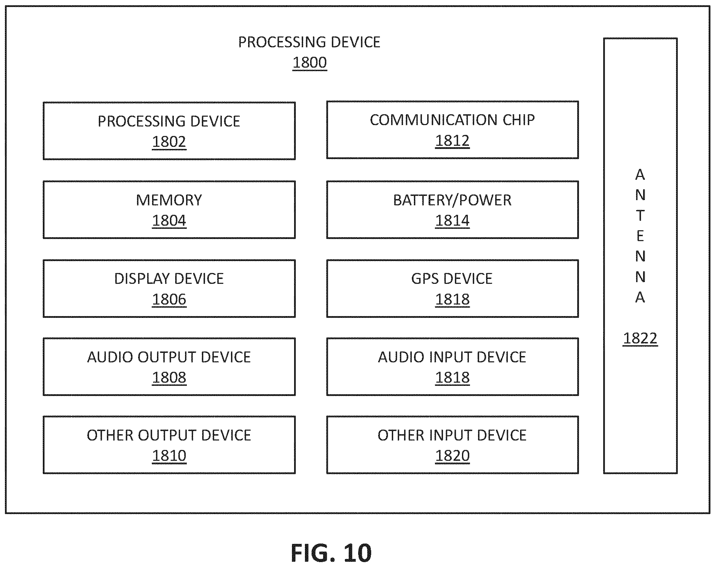

FIG. 7A and 7B are top views of a wafer and dies that include one or more IC structures with one or more carbon S/D contacts in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1-5, or any further embodiments of the IC structures described herein). After the fabrication of the semiconductor product is complete (e.g., after manufacture of one or more IC structures with one or more carbon S/D contacts as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more IC structures with carbon S/D contacts as disclosed herein may take the form of the wafer 1500 (e.g., not singulated) or the form of the die 1502 (e.g., singulated). The die 1502 may include one or more transistors (e.g., one or more of the transistors 1640 of FIG. 8, discussed below) and/or supporting circuitry to route electrical signals to the transistors, as well as any other IC components (e.g., one or more IC structures with carbon S/D contacts). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array.

FIG. 8 is a cross-sectional side view of an IC device 1600 that may include one or more IC structures with one or more carbon S/D contacts in accordance with any of the embodiments disclosed herein. The IC device 1600 may be formed on a substrate 1602 (e.g., the wafer 1500 of FIG. 7A) and may be included in a die (e.g., the die 1502 of FIG. 7B). The substrate 1602 may be any substrate as described herein. The substrate 1602 may be part of a singulated die (e.g., the dies 1502 of FIG. 7B) or a wafer (e.g., the wafer 1500 of FIG. 7A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 8 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more carbon S/D contacts at any suitable location in the IC device 1600. For example, the S/D contacts 1624 may be formed from graphite-like carbon or include graphite-like carbon, e.g., in a region of the S/D contact 1624 adjacent to the S/D regions 1620.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 8 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 8). Although a particular number of interconnect layers 1606-1610 is depicted in FIG. 8, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 8. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 8. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

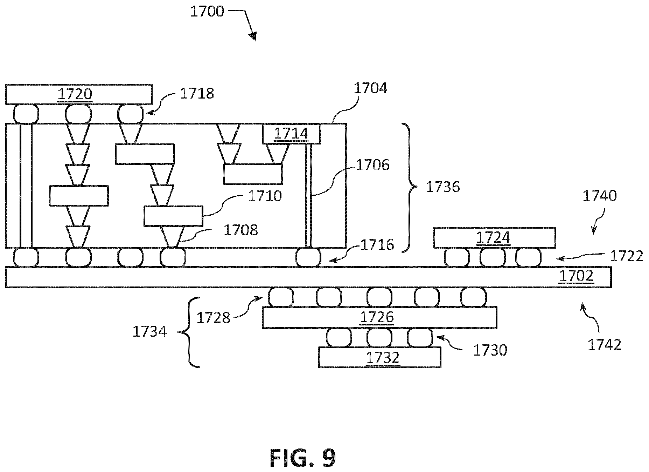

FIG. 9 is a cross-sectional side view of an IC device assembly 1700 that may include components having or being associated with (e.g., being electrically connected by means of) one or more IC structures with carbon S/D contacts in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the carbon S/D contacts, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 7B), an IC device (e.g., the IC device 1600 of FIG. 8), or any other suitable component. In some embodiments, the IC package 1720 may include carbon S/D contacts, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 9, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The interposer 1704 may further include carbon S/D contacts, as described herein. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example computing device 1800 that may include one or more components including one or more IC structures with one or more carbon S/D contacts in accordance with any of the embodiments disclosed herein. For example, any suitable ones of the components of the computing device 1800 may include a die (e.g., the die 1502 of FIG. 7B) having carbon S/D contacts as described herein. Any one or more of the components of the computing device 1800 may include, or be included in, an IC device 1600 (FIG. 8). Any one or more of the components of the computing device 1800 may include, or be included in, an IC device assembly 1700 (FIG. 9).

A number of components are illustrated in FIG. 10 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 10, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an IC device including a transistor including a gate and a channel, the channel including oxygen and a metal; and an S/D contact coupled to the channel, the S/D contact including carbon.

Example 2 provides the IC device of example 1, further including a second S/D contact, the second S/D contact including carbon.

Example 3 provides the IC device of example 1 or 2, where the channel includes a first S/D region and a second S/D region formed therein, the S/D contact coupled to the first S/D region.

Example 4 provides the IC device of any of examples 1-3, where the S/D contact includes a first layer and a second layer, the first layer between the channel and the second layer.

Example 5 provides the IC device of example 4, where the first layer includes carbon, and the second layer includes titanium and nitrogen.

Example 6 provides the IC device of example 4 or 5, where the first layer has a thickness between 0.5 nanometers and 20 nanometers, e.g., between 1 nanometers and 10 nanometers.

Example 7 provides the IC device of example 1, where the S/D contact has a thickness between 1 nanometers and 50 nanometers, e.g., between 30 nanometers and 40 nanometers.

Example 8 provides the IC device of any of examples 1-7, where the carbon in the S/D contact is a graphite-like carbon.

Example 9 provides the IC device of any of examples 1-8, where the metal of the channel includes indium.

Example 10 provides the IC device of any of examples 1-9, where the metal of the channel includes zinc.

Example 11 provides the IC device of any of examples 1-10, where the metal of the channel includes gallium.

Example 12 provides the IC device of example 1, where the metal of the channel includes indium, gallium, and zinc.

Example 13 provides an IC device including a channel including oxygen and a metal; a first S/D contact coupled to the channel, the first S/D contact including carbon; a second S/D contact coupled to the channel; and a capacitor coupled to the second S/D contact.

Example 14 provides the IC device of example 13, where the second S/D contact includes carbon.

Example 15 provides the IC device of example 13 or 14, where the first S/D contact includes a first layer and a second layer, the first layer between the channel and the second layer.

Example 16 provides the IC device of example 15, where the first layer includes carbon, and the second layer includes titanium and nitrogen.

Example 17 provides the IC device of example 15 or 16, where the first layer has a thickness between 0.5 nanometers and 20 nanometers, e.g., between 1 nanometers and 10 nanometers.

Example 18 provides the IC device of any of examples 15-17, where the second S/D contact includes a first layer and a second layer, the first layer of the second S/D contact between the channel and the second layer, and the second layer of the second S/D contact between the first layer and the capacitor.

Example 19 provides the IC device of example 13 or 14, where the first and second S/D contacts have a thickness between 1 nanometers and 50 nanometers, e.g., between 30 nanometers and 40 nanometers.

Example 20 provides the IC device of any of examples 13-19, where the carbon in the first S/D contact is a graphite-like carbon.

Example 21 provides the IC device of any of examples 13-20, where the metal of the channel includes indium.

Example 22 provides the IC device of any of examples 13-21, where the metal of the channel includes zinc.

Example 23 provides the IC device of any of examples 13-22, where the metal of the channel includes gallium.

Example 24 provides the IC device of example 13, where the metal of the channel includes indium, gallium, and zinc.

Example 25 provides a method for fabricating an IC device including: forming a semiconductor channel including oxygen and a metal; forming an S/D in the semiconductor channel; and forming an S/D contact coupled to the S/D region, the S/D contact including carbon.

Example 26 provides the method of example 25, where the S/D contact is a thin film deposited over the S/D region, the thin film having a thickness between 1 nanometer and 40 nanometers.

Example 27 provides the method of example 25 or 26, further including forming a second S/D region in the semiconductor channel, and forming a second S/D contact coupled to the second S/D region, the second S/D contact including carbon.

Example 28 provides the method of any of examples 25-28, where the metal of the semiconductor channel includes indium and zinc.

Example 29 provides the method of example 28, where the metal of the semiconductor channel further includes gallium.

Example 30 provides the method of example 25, further including forming a gate stack coupled to the semiconductor channel.

Example 31 provides an IC package that includes an IC die, including one or more of the IC devices according to any one of the preceding examples. The IC package may also include a further component, coupled to the IC die.

Example 32 provides the IC package according to example 31, where the further component is one of a package substrate, a flexible substrate, or an interposer.

Example 33 provides the IC package according to examples 31 or 32, where the further component is coupled to the IC die via one or more first level interconnects.

Example 34 provides the IC package according to example 33, where the one or more first level interconnects include one or more solder bumps, solder posts, or bond wires.

Example 35 provides a computing device that includes a circuit board; and an IC die coupled to the circuit board, where the IC die includes one or more of the memory/IC devices according to any one of the preceding examples (e.g., memory/IC devices according to any one of examples 1-30), and/or the IC die is included in the IC package according to any one of the preceding examples (e.g., the IC package according to any one of examples 31-34).

Example 36 provides the computing device according to example 35, where the computing device is a wearable computing device (e.g., a smart watch) or hand-held computing device (e.g., a mobile phone).

Example 37 provides the computing device according to examples 35 or 36, where the computing device is a server processor.

Example 38 provides the computing device according to examples 35 or 36, where the computing device is a motherboard.

Example 39 provides the computing device according to any one of examples 35-38, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a transistor comprising a gate and a channel, the channel comprising oxygen and a metal; and
a source or drain (S/D) contact coupled to the channel, the S/D contact comprising carbon.

2. The IC device of claim 1, further comprising a second S/D contact, the second S/D contact comprising carbon.

3. The IC device of claim 1 or 2, wherein the channel comprises a first S/D region and a second S/D region formed therein, the S/D contact coupled to the first S/D region.

4. The IC device of any of claims 1-3, wherein the S/D contact comprises a first layer and a second layer, the first layer between the channel and the second layer.

5. The IC device of claim 4, wherein the first layer comprises carbon, and the second layer comprises titanium and nitrogen.

6. The IC device of claim 4 or 5, wherein the first layer has a thickness between 0.5 nanometers and 20 nanometers.

7. The IC device of any of claims 1-6, wherein the S/D contact has a thickness between 1 nanometer and 50 nanometers.

8. The IC device of any of claims 1-7, wherein the carbon in the S/D contact is a graphite-like carbon.

9. The IC device of any of claims 1-8, wherein the metal of the channel comprises at least one of indium, gallium, and zinc.

10. The IC device of any of claims 1-9, further comprising:
a second S/D contact coupled to the channel material; and
a capacitor coupled to the second S/D contact.

11. The IC device of claim 10, wherein the second S/D contact comprises carbon.

12. The IC device of claim 10 or 11, wherein the second S/D contact comprises a first layer and a second layer, the first layer of the second S/D contact between the channel and the second layer, and the second layer of the second S/D contact between the first layer and the capacitor.

13. A method for fabricating an integrated circuit (IC) device comprising:
forming a semiconductor channel comprising oxygen and a metal;
forming a source or drain (S/D) region in the semiconductor channel; and
forming an S/D contact coupled to the S/D region, the S/D contact comprising carbon.

14. The method of claim 13, wherein the S/D contact is a thin film deposited over the S/D region, the thin film having a thickness between 1 nanometer and 40 nanometers.

15. The method of claim 13 or 14, further comprising:
forming a second S/D region in the semiconductor channel; and
forming a second S/D contact coupled to the second S/D region, the second S/D contact comprising carbon.
